# EUROPEAN PATENT SPECIFICATION

(11) **EP 2 604 574 B1**
(45) Date of publication and mention of the grant of the patent: **20.02.2019**
(21) Application number: 12195308.7
(22) Date of filing: 03.12.2012
(51) Int. Cl.: G02B 5/20, G02F 1/21, G02B 26/00, B82Y 20/00, G02F 1/017

(54) **Transmissive image modulator using multi-fabry-perot resonant mode and multi-absorption mode**
Lichtdurchlässiger Bildmodulator mithilfe eines Multi-Fabry-Perot-Resonanzmodus und Multiabsorptionsmodus
Modulateur d'image transmissif utilisant un mode résonant Fabry-Pérot multiple et un mode à absorption multiple

(30) Priority: 12.12.2011 KR 20110133052
(43) Date of publication of application: 19.06.2013
(73) Proprietor: Samsung Electronics Co., Ltd., Gyeonggi-do 443-742 (KR); Gwangju Institute Of Science And Technology, Gwangju (KR)
(72) Inventor: Cho, Yong-chul, Gyeonggi-do 449-712 (KR); Lee, Yong-tak, Gwangju (KR); Na, Byung-hoon, Gwangju (KR); Park, Chang-young, Gyeonggi-do 449-712 (KR); Park, Yong-hwa, Gyeonggi-do 449-712 (KR); You, Jang-woo, Gyeonggi-do 449-712 (KR); Choi, Hee-ju, Gwangju (KR)
(74) Representative: Elkington & Fife LLP

(56) References cited:
- EP-A2- 2 360 512
- US-A1- 2002 176 474
- US-A1- 2004 144 984
- US-A1- 2011 068 270
- US-A1- 2012 162 380

## Description

### FIELD OF THE INVENTION

Apparatuses and methods consistent with exemplary embodiments relate to a transmissive image modulator, and more particularly, to a transmissive image modulator that allows image modulation over a wide bandwidth by using a multi-Fabry-Perot resonant mode and a multi-absorption mode.

### BACKGROUND OF THE INVENTION

Images captured by general cameras do not contain information about a distance from the camera to a pictured subject. In order to implement a three dimensional (3D) image capture device, such as, a 3D camera, an additional component to measure distances from multiple points on the surface of the pictured subject is required. The information about the distance to the pictured subject can generally be obtained by a vision method that uses two cameras, or by triangulation that uses structured light and a camera. However, with these methods, accurate distance information is hardly obtained because the accuracy of the distance information drastically degrades as the distance to the pictured subject gets farther, and it depends on the status of the surface of the pictured subject.

A Time-of-Flight (TOF) method has been introduced to obtain more accurate distance information. The TOF method is used to measure the time that takes a laser beam from being irradiated to and reflected back from the pictured subject until the reflected beam is received by a light receptor. According to the TOF method, a beam of a certain wavelength (e.g., a near-infrared beam of 850 nm) having been projected from a light-emitting diode (LED) or a laser diode (LD) to the pictured subject, reflected back from the pictured subject in kind, and then finally received by the light receptor undergoes a special process for extracting the distance information. Various TOF methods have been introduced depending on such light handling processes. For instance, in a direct time-measurement method, the time that takes a pulse beam from being projected to the pictured subject to being reflected back from the pictured subject is measured with a timer. In a correlation method, the distance is measured based on brightness of the pulse beam that has been projected to and then reflected back from the pictured subject. A phase delay measurement method projects a continuous wave beam to the pictured subject, detects a phase difference in the beam reflected back from the pictured subject, and then calculates the phase difference as a distance.

In addition, there are many different phase delay measurement methods, among which it is advantageous to use an external modulation method to obtain a higher resolution distance image by performing amplitude modulation on the reflected beam and photographing the modulated reflected beam with a photography device, such as, a charge-coupled device (CCD) or Complementary Metal Oxide Semiconductor (CMOS) to measure a phase delay. In the external modulation method, a brightness image can be obtained by accumulating or sampling the amount of incoming light for a predetermined time, and the phase delay and the distance can be calculated from the brightness image. In the external modulation method, a normal photography device may be used as is, but a light modulator is required to modulate light super fast at tens to hundreds of MHz rates, in order to obtain an accurate phase delay.

Among light modulators, there is, for example, an image intensifier or a transmissive modulator using a Pockel or Kerr effect based on crystal optics, but both of these have several defects, including large volume, operation at a high voltage of several kV, and cost ineffectiveness.

Recently, a compact, low voltage-driven, and GaAs semiconductor-based light modulator, which is also easy to implement, has been proposed. The GaAs semiconductor-based light modulator has a multiple quantum well layer disposed between p-and n-electrodes and uses a light absorption effect within a MOW layer when a reverse bias voltage is applied to the p- and n-electrodes. The GaAs semiconductor-based light modulator has advantages in that it is fast driven, operates at a relatively low driving voltage, and has a large reflectivity difference (i.e., contrast) when operating between ON and OFF. On the other hand, the GaAs semiconductor-based light modulator has quite a narrow bandwidth of 4-5 nm.

A 3D camera uses multiple light sources, between which there is a variation in the center wavelength. Furthermore, the center wavelength of a light source may vary with temperature. Likewise, the light modulator has a varying characteristic in the center absorption wavelength depending on variables of a manufacturing process and changes in temperature. Accordingly, a light modulator capable of modulating beams over a wide bandwidth is required to be applied in the 3D camera. However, since there is a trade-off between the reflectivity difference in ON/OFF operations and bandwidth, it is difficult to increase both of them simultaneously.

In a reflective modulator, an optical path for providing a modulated optical image to a photography device (e.g., CCD, CMOS) is complicated. Accordingly, an additional configuration of an optical system is required.

United States Patent Application Publication Number US 2002/0176474 A1 discloses a quantum dot vertical cavity surface-emitting laser having a low threshold gain.

United States Patent Application Publication Number US 2012/0162380 A1 presents an optical modulator that performs wide bandwidth optical modulation using multiple Fabry-Perot resonant modes.

United States Patent Application Publication Number US 2004/0144984 A1 discloses a method for fabricating a surface emitting semiconductor device.

United States Patent Application Publication Number US 2011/068270 A1 presents apparatus for generating/detecting terahertz wave.

European Patent Application Publication Number E 2360512 A2 discloses an optical modulator having wide bandwidth based on Fabry-Perot resonant reflection.

### SUMMARY OF THE INVENTION

One or more exemplary embodiments may provide a transmissive image modulator for performing image modulation over a wide bandwidth which is easy to manufacture and has a big transmittance difference.

Additional aspects will be set forth in part in the description which follows and, in part, will be apparent from the description, or may be learned by practice of the presented exemplary embodiments.

According to an aspect of the invention, there is provided a transmissive image modulator according to claim 1.

The first lower reflection layer may include first pairs of the first and second refractive index layers, the first micro-cavity layer may consist of the first refractive index layer, the first phase matching layer may consist of the second refractive index layer, and the second lower reflection layer may include second pairs of the first and second reflective layers.

A number of first pairs may be less than a number of second pairs.

The upper reflection layer may include a first upper reflection layer, a second phase matching layer disposed on the first upper reflection layer, a second micro-cavity layer disposed on the second phase matching layer, and a second upper reflection layer disposed on the second micro-cavity layer.

The first upper reflection layer may include third pairs of the first and second refractive index layers, the second phase matching layer may include the second refractive index layer, the second micro-cavity layer may include the first refractive index layer, and the second upper reflection layer may include fourth pairs of the first and second reflective layers.

A number of third pairs may be larger than a number of fourth pairs.

The lower and upper reflection layers may be structured symmetrically about the active layer.

The first lower and second upper reflection layers may have the same reflectance, and the second lower and the first upper reflection layers may have the same reflectance.

A phase of light reflected on the surface of the second upper reflection layer may lag by π, while phases of light reflected on surfaces of the first lower reflection layer, the second lower reflection layer, and the first upper reflection layer may be 0.

The first refractive index layer may be made from AlₓGa₁₋ₓAs, and the second refractive index layer may be made from Al_{y}Ga_{1-y}AS, where 0 < x < 1, 0 < y < 1, and x < y.

The active layer may include the plurality of quantum well layers and the plurality of barrier layers stacked alternately, a first cladding layer disposed between the lower reflection layer and the active layer, and a second cladding layer disposed between the upper reflection layer and the active layer.

The first cladding layer may have a refractive index between those of the quantum well layer and the upper reflection layer, the second cladding layer may have a refractive index between those of the quantum well layer and the lower reflection layer, and the first and second cladding layers may be made from the same material and have the same thickness.

The multiple quantum well layer may include first and second quantum well layers with different thicknesses.

The transmissive image modulator may further include a first contact layer disposed on a lower surface of the lower reflection layer, and a second contact layer disposed on a top layer of the upper reflection layer.

The first contact layer may be made from n-GaAs or n-InGaP.

The transmissive image modulator may further include a substrate disposed on the lower surface of the first contact layer, and a transparent widow formed in the center of the substrate by removing the central part of the substrate.

The transmissive image modulator may further include a transparent resin applied to the second contact layer, and a transparent cover disposed on the transparent resin.

According to an aspect of another exemplary embodiment, there is provided a method of forming a transmissive image modulator on a substrate according to claim 11.

The first contact layer may be made from n-GaAs, the forming of the first contact layer on the substrate may include forming at first an AlAs buffer layer on the substrate, and forming the first contact layer on the AlAs buffer layer.

The forming of the transparent window by removing a central part of the substrate may include forming a first protection layer on a bottom surface of the substrate and forming a second protection layer on a top surface of the second contact layer; forming a photoresist layer along an edge of the first protection layer, and removing a central part of the first protection layer to expose the substrate; removing the exposed substrate with a dry etching until the buffer layer is almost exposed; removing the remaining part of the substrate with a wet etching method to expose the buffer layer; and removing the exposed buffer layer and the first and second protection layers.

The first contact layer may be made from n-InGaP.

The forming of the transparent window by removing the central part of the substrate may include forming a first protection layer on a bottom surface of the substrate and forming a second protection layer on a top surface of the second contact layer; forming a photoresist layer along an edge of the first protection layer, and removing a central part of the first protection layer to expose the substrate; removing an exposed part of the substrate with a wet etching method to expose the buffer layer; and removing the exposed buffer layer and the first and second protection layers.

### BRIEF DESCRIPTION OF THE EMBODIMENTS

These and/or other exemplary aspects and advantages will become apparent and more readily appreciated from the following description of exemplary embodiments, taken in conjunction with the accompanying drawings in which:
FIG. 1 is a cross-sectional view of a schematic structure of an image modulator according to an exemplary embodiment;
FIGS. 2A to 4B illustrate simple principles of how bandwidths of the image modulator increase according to a Fabry-Perot resonant mode;
FIG. 5 is a graph representing changes of transmittance peaks with the reflectance of mirrors in the multiple Fabry-Perot resonant modes at three cavities;
FIG. 6 is a graph representing changes of transmittance peaks with changes of the reflectance of mirrors in the multiple Fabry-Perot resonant modes at three cavities, where the reflectance of the mirrors is symmetrically designed;
FIGS. 7A and 7B are graphs representing light absorption characteristics of an active layer in which a single type of quantum well layer is arranged;
FIGS. 8A and 8B are graphs representing light absorption characteristics of an active layer in which two types of quantum well layers are arranged;
FIG. 9 shows a table of illustrative examples of structures and thickness of layers of the image modulator, according to an exemplary embodiment;
FIG. 10A illustrates an exemplary design result of the image modulator;
FIG. 10B is a graph representing optical characteristics of the image modulator illustrated in FIG. 10A;
FIG. 11A illustrates another exemplary design result of the image modulator, not falling under the scope of the invention;
FIG. 11B is a graph representing optical characteristics of the image modulator illustrated in FIG. 11A;
FIG. 12A illustrates another exemplary design result of the image modulator;
FIG. 12B is a graph representing optical characteristics of the image modulator illustrated in FIG. 12A;
FIG. 13A illustrates another design result of an image modulator;
FIG. 13B is a graph representing optical characteristics of the image modulator illustrated in FIG. 13A;
FIGS. 14A to 14H illustrate schematic cross-sectional views of a process of forming a transparent window of a substrate;
FIGS. 15A to 15H illustrate schematic cross-sectional views of another process of forming the transparent window of the substrate;
FIG. 16 is a schematic cross-sectional view representing an example of the image modulator having a reinforcing structure mounted on the top surface thereof; and
FIG. 17 schematically illustrates a large image modulator array including arrays of the image modulator as illustrated in FIG. 1.

### DETAILED DESCRIPTION OF THE DRAWINGS

Reference will now be made in detail to embodiments, examples of which are illustrated in the accompanying drawings, wherein like reference numerals refer to like elements throughout. In this regard, the exemplary embodiments may have different forms and should not be construed as being limited to the descriptions set forth herein. Accordingly, the exemplary embodiments are merely described below, by referring to the figures, to explain aspects of the present description. As used herein, the term "and/or" includes any and all combinations of one or more of the associated listed items. Expressions such as "at least one of," when preceding a list of elements, modify the entire list of elements and do not modify the individual elements of the list.

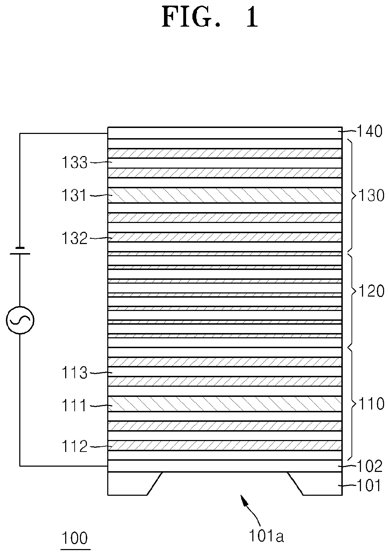

FIG. 1 is a cross-sectional view of a schematic structure of an image modulator 100 according to an exemplary embodiment. Referring to FIG. 1, the image modulator 100 may include a substrate 101, a first contact layer 102 on top of the substrate 101, a lower distributed Bragg reflector (DBR) layer 110 on top of the first contact layer 102, an active layer 120 having a multiple quantum well structure on top of the lower DBR layer 110, an upper DBR layer 130 on top of the active layer 120, and a second contact layer 140 on top of the upper DBR layer 130. Furthermore, the image modulator 100 may further include at least one of a first micro-cavity layer 111 disposed within the lower DBR layer 110, and a second micro-cavity layer 131 disposed within the upper DBR layer 130.

The substrate 101 may be made from non-doped GaAs. A center portion of the substrate 101 may be removed and a transparent window 101a may be formed, to allow the light to penetrate. The first contact layer 102 connected to an electrode (not shown) to apply a voltage to the active layer 120, and is made from silicon-doped n-GaAs or n-InGaP, for example. The second contact layer 140 is connected to another electrode (not shown) to apply a voltage to the active layer 120, and is made from beryllium (Be)-doped p-GaAs, for example.

The lower DBR layer 110 and the upper DBR layer 130 each have a structure where relatively low refractive index layers and relatively high refractive index layers are repeatedly alternately stacked. For example, the lower and upper DBR layers 110 and 130 may each consist of a number of pairs of AlxGa1-xAs and AlyGa1-yAs as high and low refractive index layers, respectively, where 0 < x < 1, 0 < y < 1, and x < y. In more detail, the lower and upper DBR layers 110 and 130 each have a structure where Al_{0.2}Ga_{0.8}As and Al_{0.87}Ga_{0.13} are alternately stacked.

When there is a beam with a certain wavelength incident on the lower and upper DBR layers 110 and 130, reflection occurs at a boundary layer between the different refractive index layers (i.e., between the high and low refractive index layers). In this regard, by ensuring that all the reflected beams are in phase, high reflectance is obtained. To do this, an optical thickness (i.e., a value resulting from multiplying physical thickness by the refractive index of a material of a layer) of each of the high and low refractive index layers within the lower and upper DBR layers 110 and 130 may be selected to be an odd-numbered multiple of λ/4, where λ is a wavelength of the incident beam or a resonant wavelength to be modulated). Reflectance at the lower and upper DBR layers 110 and 130 may increase as the number of repetitive pairs of high and low refractive index layers increases. The lower and upper DBR layers 110 and 130 have electrodes configured to form an electric field for light absorption at the active layer 120. To do this, the lower DBR layer 110 may be a Si-doped n-DBR layer with Si doping density of about 2.0∼2.6×10¹⁸/cm³, while the upper DBR layer 130 may be a Be-doped p-DBR layer with Be doping density of about 0.8∼1.2×10¹⁹/cm³.

The active layer 120 is where the light absorption occurs and has a multiple quantum well structure in which multiple quantum well layers and multiple barrier layers are stacked alternately. For example, the active layer 120 may include multiple barrier layers of Al_{0.31}Ga_{0.69}As and multiple quantum well layers of GaAs. The active layer 120 also serves as a main cavity for Fabry-Perot resonance. To do this, the active layer 120 may be formed to have an optical thickness that is the same as a multiple of λ/2.

Thus, the image modulator 100 has a P-I-N structure having the p-type upper DBR layer 130, the non-doped active layer 120, and the n-type lower DBR layer 110. In this structure, a beam incident on the image modulator 100 resonates between the upper DBR layer 130 and the lower DBR layer 110 through the active layer 120, and a beam with a wavelength λ that satisfies a resonance condition may be transmitted through the image modulator 100. At this time, by applying a reverse bias voltage to the image modulator 100, light absorption by the active layer 120 may be controlled to modulate the intensity of the transmitted beam.

Furthermore, there are the first and second micro-cavity layers 111 and 131 disposed in the lower and upper DBR layers 110 and 130, respectively. The image modulator 100 may include any one of the first and second micro-cavity layers 111 and 131 or may include both the first and second micro-cavity layers 111 and 131. The first and second micro cavity layers 111 and 131 serve as additional cavities for the Fabry-Perot resonance. To do this, each of the first and second micro cavity layers 111 and 131 may be formed to be a multiple of λ/2 in optical thickness. Materials of the first and second micro cavity layers 111 and 131 may be identical to, for example, those of either the high and low refractive index layers (e.g., Al_{0.2}Ga_{0.8}As and Al_{0.87}Ga_{0.13}As) in the lower and upper DBR layers 110 and 130. Furthermore, the first micro-cavity layer 120 may be n-type doped to forward a current to the activity layer 120, as well as the lower DBR layer 110, while the second micro-cavity layer 131 may be p-type doped.

The lower DBR layer 110 is divided by the first micro cavity layer 111 into two parts. That is, a first lower DBR layer 112 is below the first micro cavity layer 111, while a second lower DBR layer 113 is above the first micro cavity layer 111. Similarly, the upper DBR layer 130 is also divided by the second micro cavity layer 131 into two parts. That is, a first upper DBR layer 132 is below the second micro cavity layer 131, while a second upper DBR layer 133 is above the second micro cavity layer 131. Therefore, the image modulator 100 may have a multiple Fabry-Perot resonant mode based on four mirrors 112, 113, 132, and 133 and three cavities 111, 120, and 131. Using the multiple Fabry-Perot resonant mode may increase the transmission bandwidth of the image modulator 100.

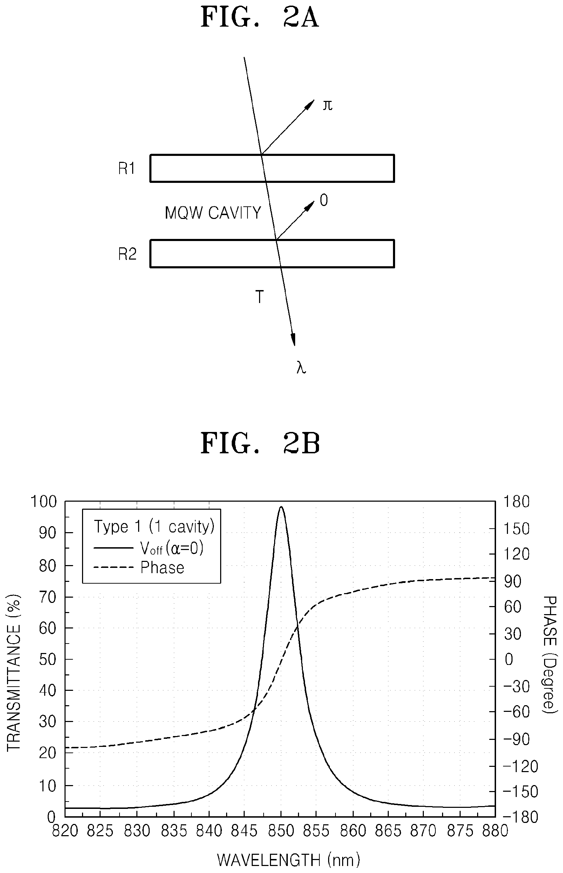

FIGS. 2A to 4B illustrate simple principles of how the transmission bandwidths of the image modulator 100 increases according to the multiple Fabry-Perot resonant mode.

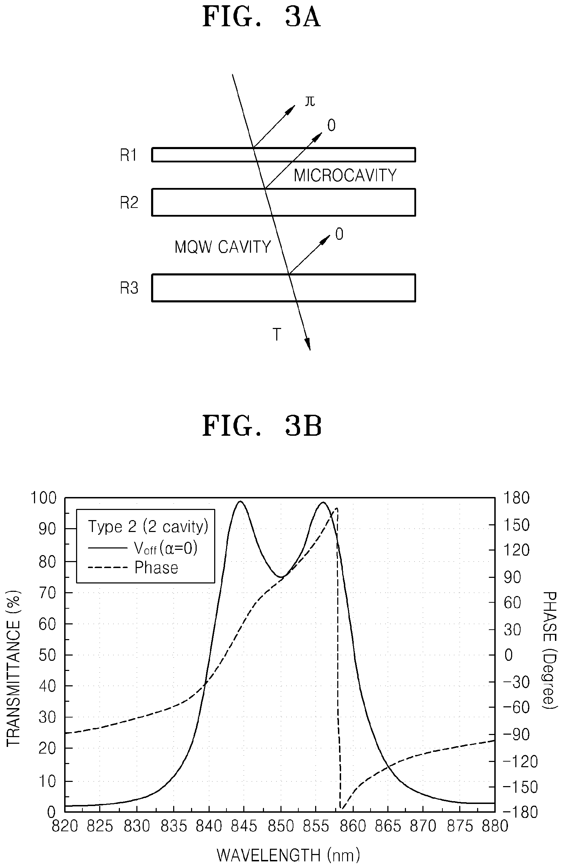

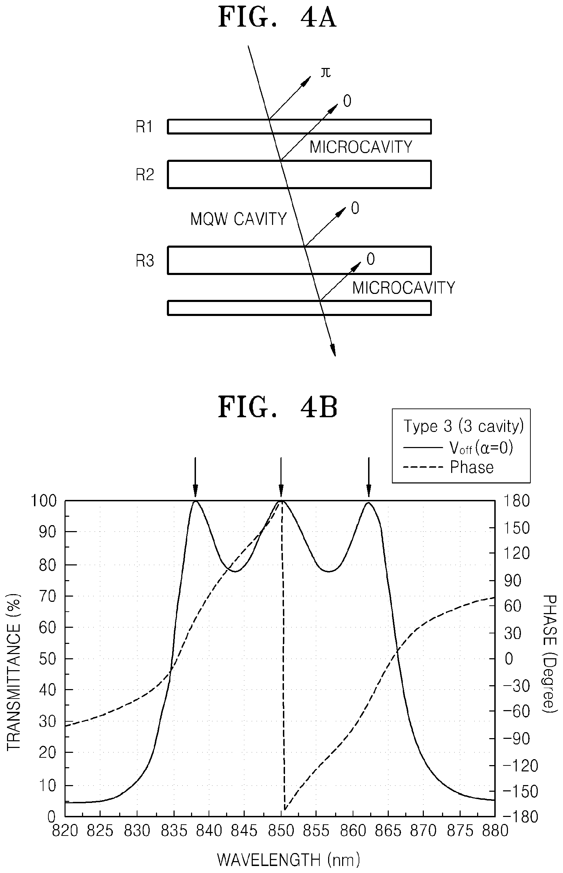

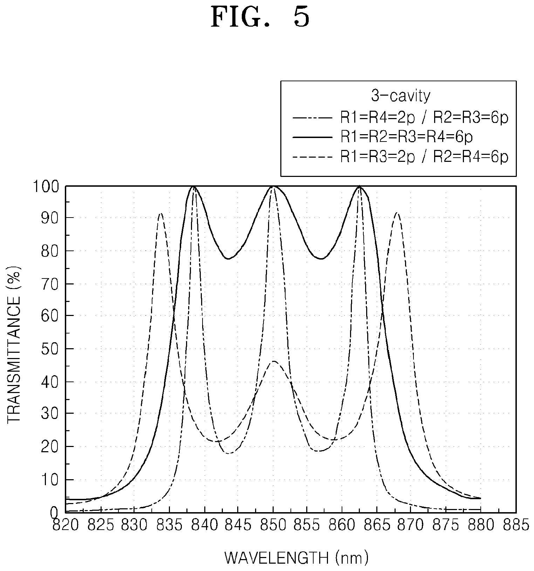

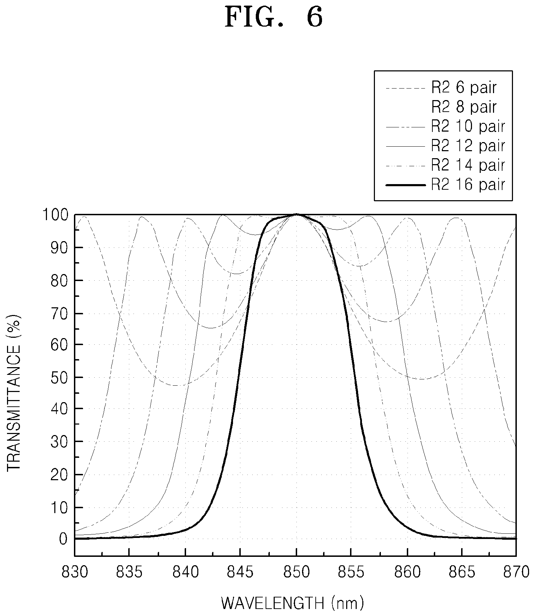

First, as shown in FIG. 2A, in a case that a single cavity is disposed between two mirrors R1 and R2, only one transmittance peak is formed as shown in FIG. 2B. In FIG. 2B, phases refer to differences in phase between incident and exiting beams to and from the image modulator 100, and the phase is zero at the Fabry-Perot resonant wavelength. Here, it is assumed that cavity absorption is zero and reflectance of the two mirrors R1 and R2 are the same. In addition, as shown in FIG. 3A, in a case that two cavities are disposed between three mirrors R1- R3, two transmittance peaks are formed as shown in FIG. 3B. Phases at the two peaks of the resonant wavelength are around 0 and 180 degrees, respectively. Furthermore, as shown in FIG. 4A, in a case that three cavities are disposed between four mirrors R1 - R4, three transmittance peaks are formed as shown in FIG. 4B. As such, as the number of cavities increases, it is possible to increase transmission bandwidth due to overlapping between resonant wavelengths. As shown in FIG. 5, in an example of using four mirrors R1-R4 and three cavities, when the mirrors' reflectance is symmetrically designed, i.e., R1=R4 and R2=R3, three transmittance peaks would be the same. Alternatively, when a middle mirror has higher reflectance than that of outer mirrors (i.e., R1=R4 < R2=R3), a flat-top transmittance characteristic may be obtained due to overlapping between the resonant wavelengths, as shown in FIG. 6. In a case where the mirrors R1-R4 are the lower and upper DBR layers 110 and 130 as shown in FIG. 1, the reflectance may be proportional to the number of pairs of high and low refractive index layers.

The transmission bandwidth of the image modulator 100 is also affected by the light absorption property of the active layer 120. In particular, a difference in transmittance, indicative of light modulation performance of the image modulator 100, (i.e., a difference in transmittance between when no voltage has been applied to the image modulator 100 and when a voltage has been applied to the image modulator 100) may be significantly affected by the light absorption property of the active layer 120 The light absorption property of the active layer 120 depends on thicknesses of the quantum well layer and the barrier layer as well as compositions of their materials. For example, as the thickness of the quantum well layer increases while other conditions remain constant, an absorption coefficient peak shifts more toward long wavelengths.

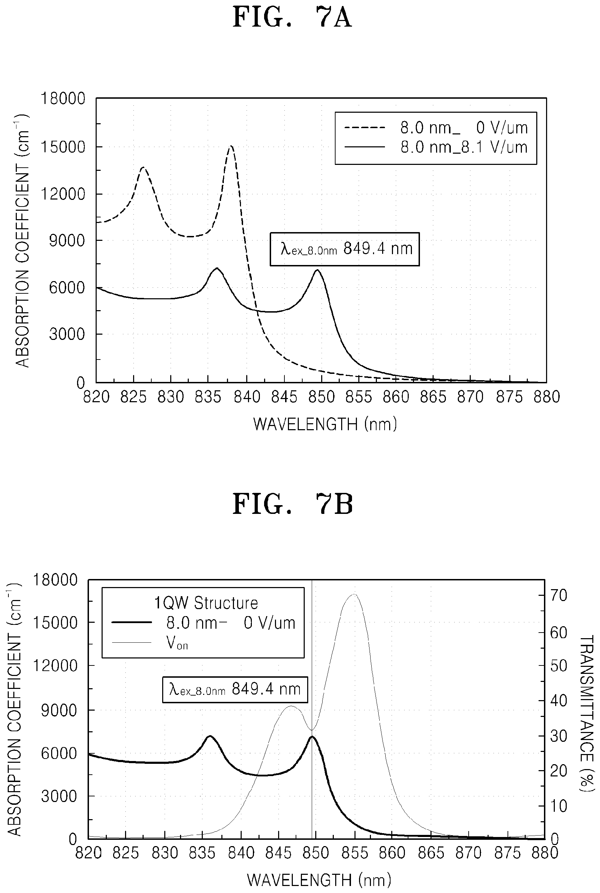

FIGS. 7A and 7B are graphs representing light absorption characteristics of an active layer in which only a single type of quantum well layer (e.g., a quantum well layer that is about 8 nm thick) is arranged. Here, it is assumed that the active layer 120 is designed to have an about 850 nm resonant wavelength. Referring to FIG. 7A, when no voltage has been applied to the image modulator 100, there is exciton absorption that occurs at the active layer 120 at a lower wavelength than the resonant wavelength but there is almost no absorption at the resonant wavelength, as indicated by a dashed line . Alternatively, when a reverse bias voltage (e.g., about -8.1 V/um) has been applied to the image modulator 100, an exciton peak shifts toward long wavelengths with decreased magnitude, as indicated by a solid line. Here, the exciton peak (e.g., at about 849.4 nm) nearly occurs at the resonant wavelength. Then, as shown in FIG. 7B, transmittance at the resonant wavelength is lowered.

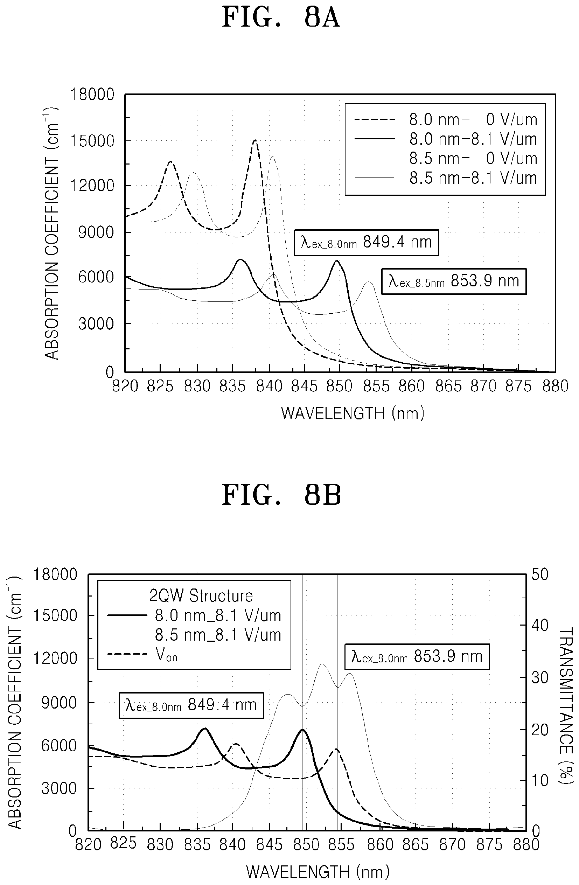

FIGS. 8A and 8B are graphs representing light absorption characteristics of the active layer 120 in which two types of quantum well layers (e.g., quantum well layers being that are about 8 nm and about 8.5 nm thick) are arranged. Similarly here, it is assumed that the active layer 120 is designed to have an 850 nm resonant wavelength. Referring to FIG. 8A, the exciton absorption occurs at each of the about 8 nm and about 8.5 nm quantum well layers. When a reverse bias voltage is applied to the image modulator 100, each of the exciton peaks shifts toward long wavelengths, i.e., the exciton peak in the about 8 nm quantum well layer shifts to about 849.4 nm, and that of the about 8.5 nm quantum well layer shifts to about 853.9 nm. As shown in FIG. 8B, relatively low transmittance may be obtained over a wide range of wavelengths, due to the two exciton peaks near the resonant wavelength.

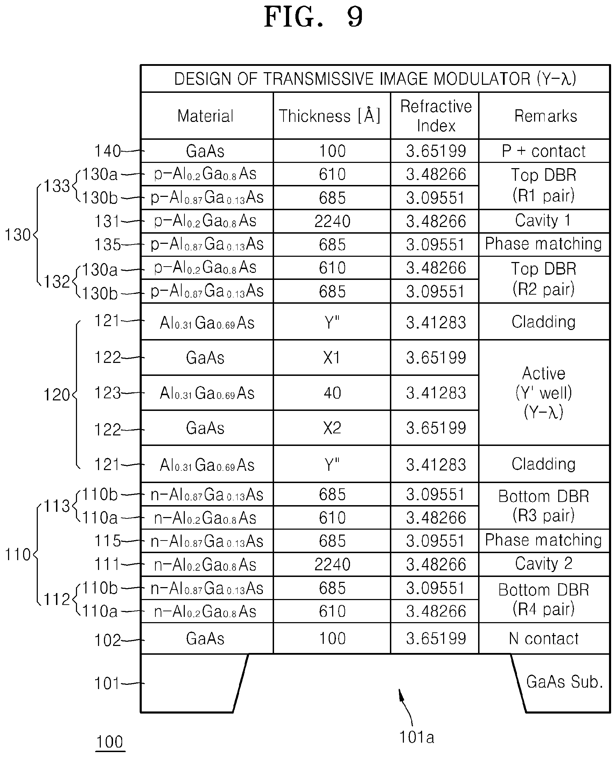

FIG. 9 shows a table of illustrative examples of structures and thickness of layers of the image modulator 100, according to an exemplary embodiment, considering what is described above. The image modulator 100 according to the table shown in FIG. 9 is designed to have about an 850 nm center absorption wavelength with a GaAs compound semiconductor. Referring to FIG. 9, the second contact layer 140, which serves as a p-contact layer, is made from p-GaAs. It is desirable to use a GaAs material to form an ohmic contact in forming an electrode, because the GaAs material has low oxidation rate on its surface and has a small band gap. The thickness of the second contact layer 140 may be about 100Å considering an absorption loss of the incident beams.

The upper DBR layer 130 is disposed under the second contact layer 140. The upper DBR layer 130 may include a first upper DBR layer 132, a phase matching layer 135, a second micro-cavity layer 131, and a second upper DBR layer 133. The second upper DBR layer 133 has a structure in which high and low refractive index layers 130a and 130b are alternately stacked in order from the top. The high refractive index layer 130a may, for example, be made from Al_{0.2}Ga_{0.8}As having a 3.483 refractive index, and in this case the thickness of the high refractive index layer 130a may be about 610Å. Then, the optical thickness of the high refractive index layer 130a may be λ/4 (= 850 nm/4 = physical thickness× refractive index (= 610Å×3.483)). The low refractive index layer 130b may, for example, be made from Al_{0.87}Ga_{0.13}As having a 3.096 refractive index, and in this case the thickness of the low refractive index layer 130b may be about 685Å. Then, the optical thickness of the low refractive index layer 130b may be λ/4 (= 850 nm/4 = physical thickness× refractive index (= 685Å ×3.096)). However, materials for the high and low refractive index layers 130a and 130b are not limited to the above examples, and other types and compound ratios of materials may also be used for the high and low refractive index layers 130a and 130b.

The second micro cavity layer 131 is disposed under the second upper DBR layer 133. Since there is the low refractive index layer 130b disposed in the bottom of the second upper DBR layer 133, the second micro-cavity layer 131 may be formed with Al_{0.2}Ga_{0.8}AS, the same material as the high refractive index layer 130a. the thickness of the second micro-cavity layer 131 may be about 2440Å so that it may have an optical thickness λ. However, the optical thickness of the second micro-cavity layer 131 is not limited to λ, and may be properly selected from among multiples of λ/2. Furthermore, if the high refractive index layer 130a is disposed on the bottom of the second upper DBR layer 133, the material of the second micro-cavity layer 131 can be the same as the low refractive index layer 130b.

The phase matching layer 135 is disposed under the second micro-cavity layer 131, which has a thickness of λ/4. The phase matching layer 135 is included to allow the high and low refractive layers 130a and 130b to alternate with each other within the upper DBR layer 130. Accordingly, if the second micro-cavity layer 131 is made from the same material as the high refractive index layer 130a, the phase matching layer 135 may be made from the same material as the low refractive index layer 130b. Alternatively, If the second micro-cavity layer 131 is made from the same material as the low refractive index layer 130b, the phase matching layer 135 may be made from the same material as the high refractive index layer 130a.

The first upper DBR layer 132 is disposed under the phase matching layer 135. Similarly with the second upper DBR layer 133, the first upper DBR layer 132 also has a structure in which the high and low refractive index layers 130a and 130b are alternately stacked. Because the phase matching layer 135 is made from the same material as the low refractive index layer 130b, the high refractive index layer 130a may be disposed first right under the phase matching layer 135.

As discussed above, the upper DBR layer 130 that includes the first upper DBR layer 132, the phase matching layer 135, the second micro-cavity layer 131, and the second upper DBR layer 133 is arranged such that the high and low refractive index layers 130a and 130b, each having a thickness of λ/4, alternate with each other. However, the second micro-cavity layer 131 is not λ/4 but a multiple of λ/2 in optical thickness. As such, for the formation of the upper DBR layer 130, implementing the exact thickness of each film layers may be crucial. To do this, for example, with in-situ optical reflectometry, measurement and growth of respective film layers may be achieved. In other words, while a film layer is growing as white light is projected into Molecular Beam Epitaxy (MBE) equipment, beams reflecting back into a substrate may be sensed and used to fine tune the thickness of the respective film layers.

In addition, as already described earlier, the upper DBR layer 130 may serve as a passage through which a current flows. Thus, materials for the first upper DBR layer 132, the phase matching layer 135, the second micro-cavity layer 131, and the second upper DBR layer 133 may be p-doped using Be as a dopant. The doping concentration may be about 0.8∼1.2×10¹⁹/cm³.

The active layer 120 is disposed under the upper DBR layer 130, which absorbs light and serves as a main cavity. The active layer 120 may include a plurality of quantum well layers 122 made of GaAs and a plurality of barrier layers 123 which are disposed between the quantum well layers 122 and made of Al₀.₃₁Ga_{0.69}As. Additionally, cladding layers 121 may further be disposed between the quantum well layer 122 and the upper DBR layer 130 and between the quantum well layer 122 and the lower DBR layer 110, respectively. The refractive index of GaAs, a material of the quantum well layer 122, is about 3.652, which causes light loss between the low refractive index layer 130b (having a refractive index of 3.096) in the upper DBR layer 130 and the quantum well layer 122, and a low refractive index layer 110b in the lower DBR layer 110 and the quantum well layer 122. Thus, to minimize the light loss, the cladding layers 121 may have a middle refractive index between those of the quantum well layer 122 and the low refractive index layers 110b and 130b. For example, the cladding layer 121 is made from Al_{0.31}Ga_{0.69}As, which has about a 3.413 refractive index.

The optical thickness of the active layer 120 serving as the main cavity may be a multiple of λ/2. For obtaining higher light absorption, the optical thickness may also be selected from among, for example, 3λ, 5λ, or 7λ. There is trade-off relation in connection with the thickness of the active layer 120, i.e., as the thickness of the active layer 120 increases, the absorption rate increases and the capacitance of an associated device decreases, but the manufacturing process becomes complicated and a driving voltage is increased. The optical thickness of the active layer 120 may be adjusted depending on the thickness and the number of quantum well layers 122 and barrier layers 123 as well as the thickness of the cladding layer 121. For example, in order to obtain a desired absorption characteristic, the thicknesses and the number of quantum well layers 122 and barrier layers 123 are set, and then the thickness of the cladding layer 121 may be selected such that the entire optical thickness of the active layer 120, including the cladding layer 121, maybe 3λ, 5λ, or 7λ.

The lower DBR layer 110 is disposed under the active layer 120. The lower DBR layer 110 may include a first lower DBR layer 112, a first micro-cavity layer 111, a phase matching layer 115, and a second lower DBR layer 113. The second lower DBR layer 113 has a structure in which low and high refractive index layers 110b and 110a are alternately stacked in order from the top. The high refractive index layer 110a may, for example, be made from Al_{0.2}Ga_{0.8}As having a 3.483 refractive index, and in this case the thickness of the high refractive index layer 110a may be about 610Å. The low refractive index layer 110b may, for example, be made from Al_{0.87}Ga_{0.13}As having a 3.096 refractive index, and in this case the thickness of the low refractive index layer 110b may be about 685Å. The phase matching layer 115 is disposed under the second lower DBR layer 113, which has an optical thickness of λ/4. The phase matching layer 115 is added so that overall, the low and high refractive layers 110b and 110a may alternate with each other within the lower DBR layer 110. For example, a material of the phase matching layer 115 may be the same as the low refractive index layer 110b.

The first micro-cavity layer 111 is disposed under the phase matching layer 115. The first micro-cavity layer 111 may be made from the same material as the high refractive index layer 110a, i.e., Al_{0.2}Ga_{0.8}As. The thickness of the first micro-cavity layer 111 may be about 2440Å so that it may have an optical thickness λ. The optical thickness of the first micro-cavity layer 111 is not limited to λ, and may be properly selected from among multiples of λ/2. If the phase matching layer 115 is made from the same material of the high refractive index layer 110a, the material of the first micro-cavity layer 111 may be the same as the low refractive index layer 110b. Lastly, the first lower DBR layer 112 may be disposed under the first micro-cavity layer 111. Similarly with the second lower DBR layer 113, the first lower DBR layer 112 also has a structure in which the low and high refractive index layers 110b and 110a are alternately stacked.

As already described above, the lower DBR layer 110 may also serve as a passage through which a current flows. Thus, materials for the first lower DBR layer 112, the first micro-cavity layer 111, the phase matching layer 115, and the second lower DBR layer 113 may be n-doped with Si as a dopant. The doping concentration may be about 2.0∼2.6×10¹⁸/cm³.

Furthermore, the first contact layer 102, which is made from n-GaAs and has a thickness of about 100Å, may be disposed under the lower DBR layer 110. The first contact layer 102 may not only be formed directly on the GaAs substrate 101, but may also be formed on an AlAs buffer layer that is previously formed. In place of the AlAs buffer layer and the n-GaAs contact layer, InGaP may be used for the first contact layer 102. The transparent window 101a may be formed in the center region of the GaAs substrate 101 in order to allow light to be transmitted without loss. The transparent window 101a may be, for example, air.

Each of the film layers, such as the lower DBR layer 110, the active layer 120, and the upper DBR layer 130 as described above, may be epitaxially grown by a molecular beam epitaxy (MBE) method. As described above, each of the film layers may be measured and grown in parallel according to a reflectance measurement method, in order to grow each of them at an exact set thickness. In this regard, the lower DBR layer 110, the active layer 120, and the upper DBR layer 130 are collectively called a "P-I-N epitaxy structure".

As illustrated in FIG. 9, the image modulator 100 has a four-mirror three-cavity structure in which there are four DBR mirrors, namely, the first lower DBR layer 112, the second lower DBR layer 113, the first upper DBR layer 132, and the second upper DBR layer 133, and three cavities, namely, the active layer 120, the first micro-cavity 111, and the second micro cavity 131. Here, the phase of light reflected on the DBR mirrors may be π, 0, 0, and 0 in the order of light incidence (see FIG. 4A). In other words, the phase in light reflected on the top surface of the second upper DBR layer 133 lags by π with respect to the incident light. Phases in light reflected on the remaining DBR layers 112, 113, and 132 may be in phase with the incident light.

The lower and upper DBR layers 110 and 130 may be symmetrically formed about the active layer 120. For example, reflectance of the second lower DBR layer 113 and the first upper DBR layer 132 may be the same, and reflectance of the first lower DBR layer 112 and the second upper DBR layer 133 may be the same. Reflectance of each DBR layer may be determined according to the number of pairs of high and low refractive index layers. In FIG. 9, R1, R2, R3, and R4 represent the number of pairs of high and low refractive index layers within the second upper DBR layer 133, first upper DBR layer 132, the second lower DBR layer 113, and the first lower DBR layer 112, respectively. R1, R1, R3, and R4 may be properly selected according to optical characteristics required by the image modulator 100. However, it is not necessary to symmetrically form the lower and upper DBR layers 110 and 130, and one of the first and second micro-cavities 111 and 131 may be omitted. Furthermore, a plurality of micro-cavities may be disposed on at least one of the lower and upper DBR layers 110 and 130.

In FIG. 9, X1 and X2 represent thicknesses of the quantum well layers 122 and, may, for example, be selected from among 7nm, 7.5nm, 8nm, and 8.5nm. XI and X2 may be the same or may be different. Y' represents the number of quantum well layers 122, and Y-λ represents the overall optical thickness of the active layer 120. Y-λ, for example, may be selected from among 3λ, 5λ, and 7λ. Y" is a thickness of the cladding layer 121, and may be determined together with X1, X2, Y', and Y after X1, X2, Y', and Y are determined.

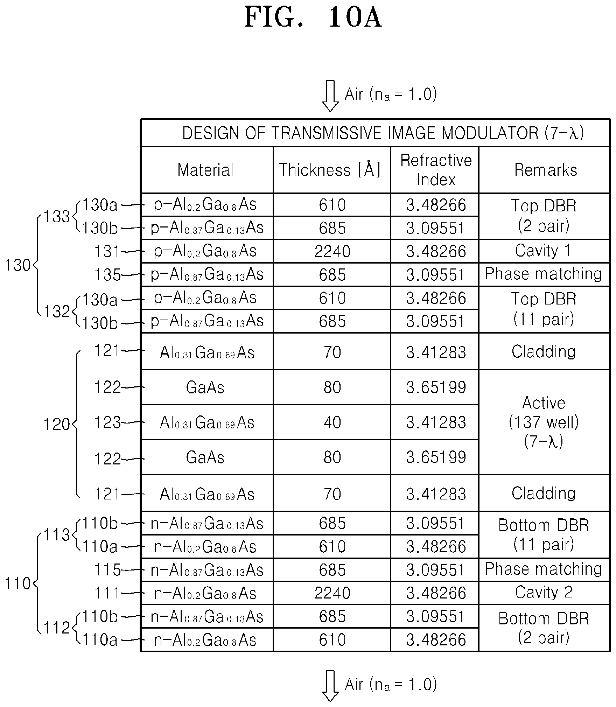

FIG. 10A shows illustrative a design result of the image modulator 100. Referring to FIG. 10A, the active layer 120 may include 137 quantum well layers 122, which are 80Å in thickness and 136 barrier layers 123, and the cladding layer 121 being 70Å in thickness. Further, the second upper DBR layer 133 has two pairs of the high and low refractive index layers, the upper DBR layer 132 has eleven pairs of the high and low refractive index layers, the second lower DBR layer 113 has eleven pairs of the high and low refractive index layers, and the first lower DBR layer 112 has two pairs of the high and low refractive index layers. The overall thickness of the active layer 120 is 7λ.

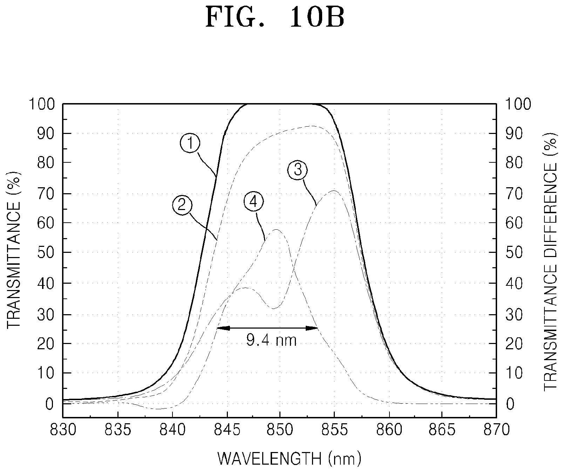

FIG. 10B is a graph representing optical characteristics of the image modulator 100 illustrated in FIG. 10A. In FIG. 10B, a line represented by ① shows transmittance characteristics of wavelengths, assuming that there is no active layer 120. A line represented by ② shows transmittance characteristics when no voltage has been applied to the image modulator 100, and a line represented by ③ shows transmittance characteristics when a reverse bias voltage has been applied to the image modulator 100. A line represented by ④ shows the difference between the transmittances of ② and ③ lines (hereinafter, referred to as a transmittance difference). As the transmittance difference becomes large and its bandwidth (e.g., half width at half maximum, HWHM) becomes large, the performance of the image modulator 100 may be improved. The bandwidth of the transmittance difference represented by line ④ is about 9.4 nm.

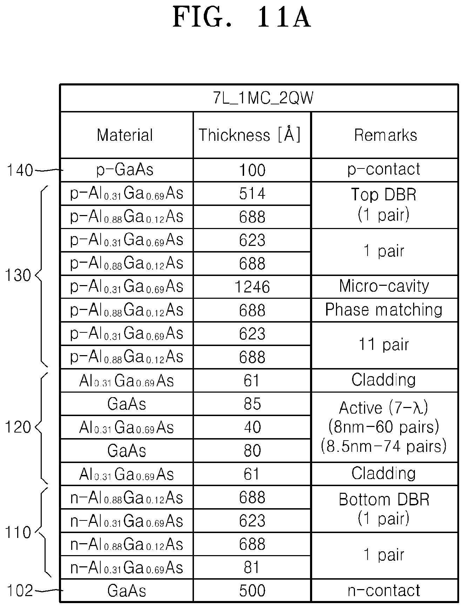

FIG. 11A illustrates another design result of the image modulator 100, not falling under the scope of the invention. Referring to FIG. 11A, only in the upper DBR layer 130 is formed the micro-cavity having a thickness of λ/2, and no micro-cavity is formed in the lower DBR layer 110. Al_{0.31}Ga_{0.69}AS is used for the high refractive index layer instead of Al_{0.2}Ga_{0.8}As, while Al_{0.88}Ga_{0.12}AS is used for the low refractive index instead of Al_{0.87}Ga_{0.13}As. The image modulator 100 may have two pairs of second upper DBR layers 133, eleven pairs of first upper DBR layers 132, a pair of second lower DBR layers 113, and a pair of first lower DBR layers 112. Furthermore, the active layer 120 includes 74 quantum well layers 122 that are about 85Å in thickness and 60 quantum well layers 122 that are about 80Å in thickness. In other words, the active layer 120 has two kinds of quantum well layers, which have different thicknesses. The thickness of the cladding layer 121 is about 61Å. The overall thickness of the active layer 120 is 7λ. The first contact layer 102 on the bottom is made from n-GaAs that is about 500 Å in thickness. In the present embodiment, the first contact layer 102 is designed to a thickness such that etch-stop may be easily implemented in a subsequent electrode formation process.

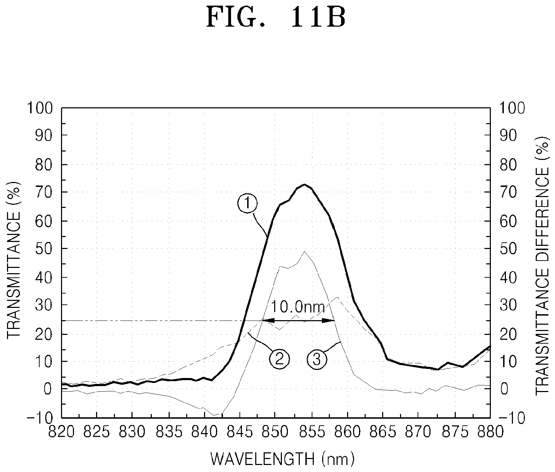

FIG. 11B is a graph representing optical characteristics of the image modulator 100 of FIG. 11A. In FIG. 11B, a line represented by ① shows transmittance characteristics when no voltage has been applied to the image modulator 100, and a line represented by ② shows transmittance characteristics when a reverse bias voltage has been applied to the image modulator 100. A line represented by ③ shows the transmittance difference between the transmittances of ① and ②. The bandwidth of the transmittance difference represented by ③ is about 10 nm.

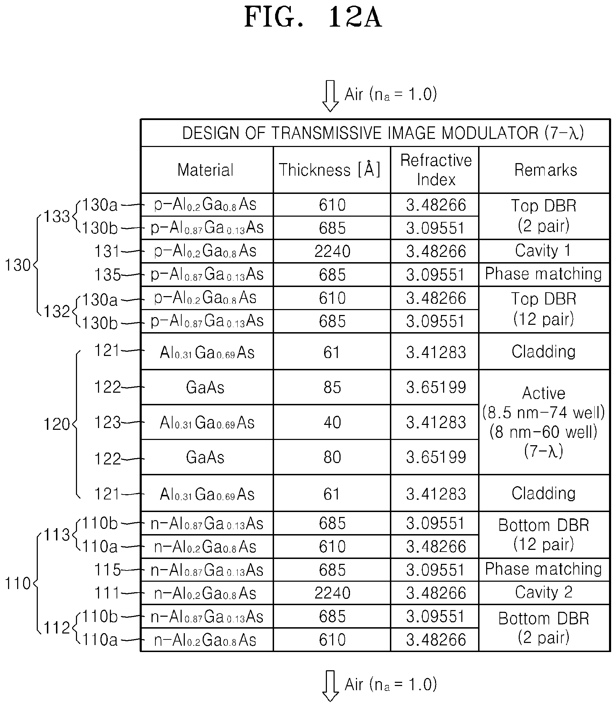

FIG. 12A shows another exemplary design result of the image modulator 100. Referring to FIG. 12A, the arrangement of the DBR layers 110 and 130 is similar to that of the DBR layers 110 and 130 shown in FIG. 10A. However, the image modulator 100 shown in FIG. 12A has 12 pairs of first and second lower DBR layers 132 and 113. The arrangement of the active layer 120 is the same as the active layer 120 shown in FIG. 11A. In detail, the active layer 120 includes 74 quantum well layers 122 having a thickness of about 85 Å and 60 quantum well layers 122 having a thickness of about 80Å. The thickness of the cladding layer 121 is 61Å, and the overall thickness of the active layer 120 is 7λ.

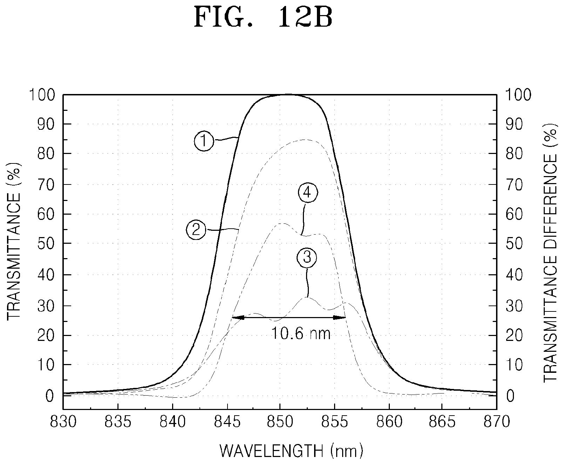

FIG. 12B is a graph representing optical characteristics of the image modulator 100 illustrated in FIG. 12A. In FIG. 12B, a line represented by ① shows transmittance characteristics of wavelengths, assuming that there is no active layer 120. A line represented by ② shows transmittance characteristics when no voltage has been applied to the image modulator 100, and a line represented by ③ shows transmittance characteristics when a reverse bias voltage has been applied to the image modulator 100. Furthermore, a line represented by ④ shows transmittance difference between the transmittances of ② and ③. The bandwidth of the transmittance difference represented by line ④ is about 10.6 nm, and the summit part of the line became smoother.

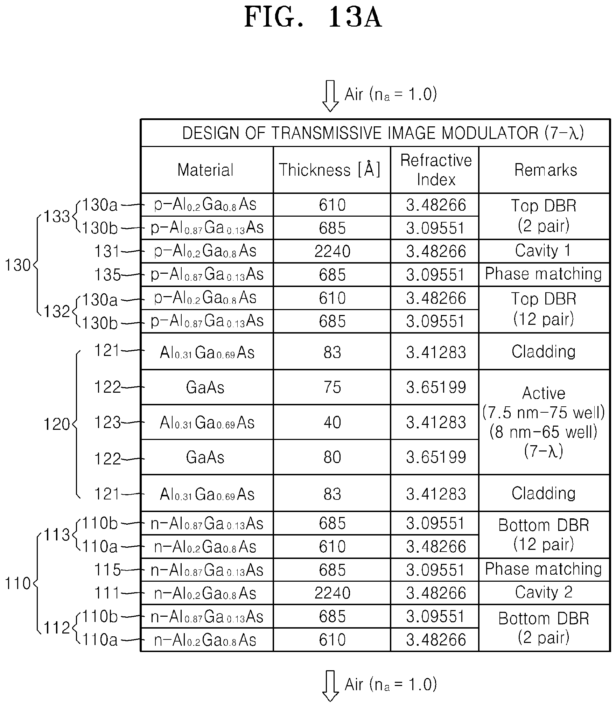

FIG. 13A shows another exemplary design result of the image modulator 100. Referring to FIG. 13A, the arrangement of the DBR layers 110 and 130 is similar to that of the DBR layers 110 and 130 shown in FIG. 12A. In detail, the active layer 120 includes 75 quantum well layers 122 having a thickness of about 75 Å and 65 quantum well layers 122 having a thickness of about 80Å. The thickness of the cladding layer 121 is about 83Å, and the overall thickness of the active layer 120 is 7λ.

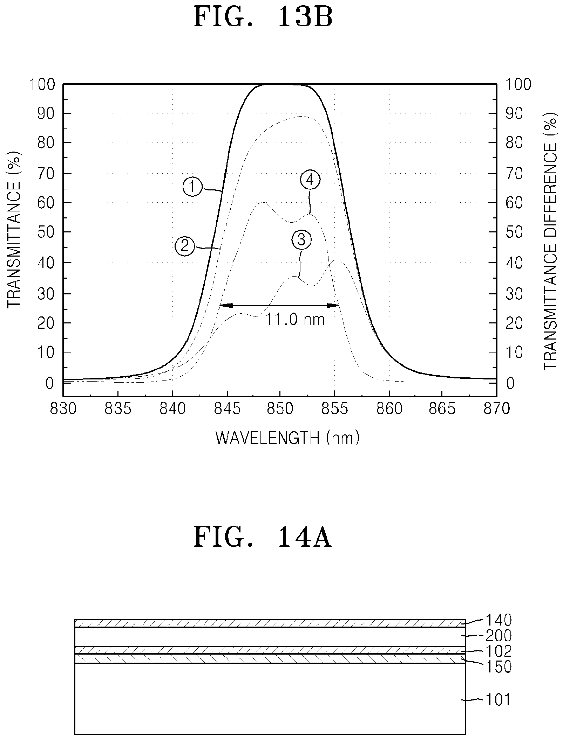

FIG. 13B is a graph representing optical characteristics of the image modulator 100 illustrated in FIG. 13A. In FIG. 13B, a line represented by ① shows transmittance characteristics of wavelengths, assuming that there is no active layer 120. A line represented by ② shows transmittance characteristics when no voltage has been applied to the image modulator 100, and a line represented by ③ shows transmittance characteristics when a reverse bias voltage has been applied to the image modulator 100. Furthermore, a line represented by ④ shows the transmittance difference between the transmittances of ② and ③. The bandwidth of the transmittance difference represented by line ④ is about 11.0 nm, and the summit part of the line became smoother.

As described above, by forming at least one micro-cavity 111, 131 in the lower and upper DBR layers 110, 130 of the transmissive image modulator 100 in the PIN structure, transmittance over a wide range of wavelengths may be improved with a resonant wavelength mode having three or more peaks. Since the micro cavities 111 and 131 are formed to thicknesses of multitudes of λ/2 with high and low refractive index materials, respectively, they may be easily implemented without a need for a separate complicated process. Having a large transmittance bandwidth and improved smoothness characteristics, the image modulator 100 may be observed to be stable from fluctuation of resonant wavelengths due to an error in the process of manufacturing or according to an external environment, such as temperature.

Since the image modulator 100 is transmissive, it is desirable to remove the GaAs substrate 101 that absorbs light having an about 850 nm waveband, so as to minimize light loss. As a way of removing the substrate 101, there is a wet etching method for completely removing the substrate 101, or an Epitaxy Lift Off (ELO) method for lifting off the substrate 101. However, such a method may possibly damage other film layers in the image modulator 100. Thus, in order to reduce uncertainty from a complicated process of removing the substrate 101, a transparent window 101a may instead be formed in a center of the substrate 101, allowing light having an about 850 nm waveband to be transmitted by removing a part of the substrate 101. However, etching the substrate 101 made from GaAs in an attempt to form the transparent window 101a may harm the first contact layer 102 made from n-GaAs on the substrate 101. Especially, the possibility of damaging the first contact layer 102 is high because the first contact layer 102 is normally formed as thin as about 50 nm so as to minimize the light loss from GaAs. However, using n-AlGaAs rather than n-GaAs for the first contact layer 102 to prevent the first contact layer 102 from being damaged from the etching makes it difficult to form an electrode thereon.

FIGS. 14A to 14H are cross-sectional views schematically representing a process of forming the transparent window 101a of the substrate 101, considering the above limitations.

First, referring to FIG. 14A, a buffer layer 150 is formed on the GaAs substrate 101. The buffer layer 150 may be made from AlAs. Then, the first contact layer 102, the epitaxy layer 200, and the second contact layer 140 are grown on the buffer layer 150 in sequence. The first contact layer 102 may be, for example, made from n-GaAs, while the second contact layer 140 may be made from p-GaAs. Here, the epitaxy layer 200 may include the lower DBR layer 110, the active layer 120, and the upper DBR layer 130.

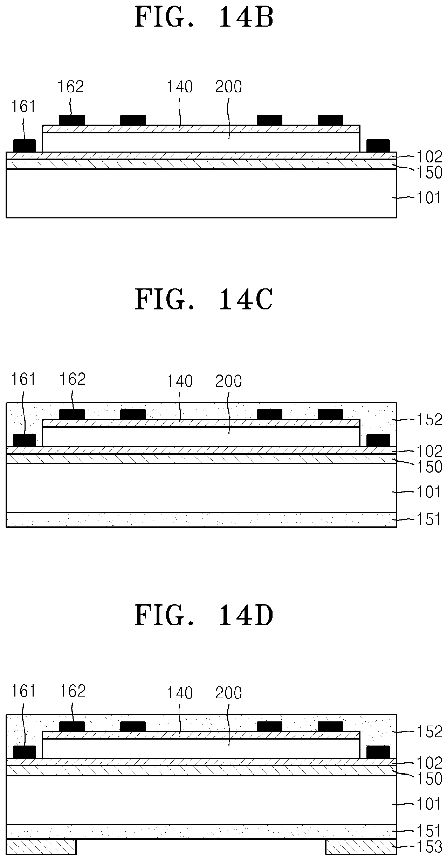

Then, referring to FIG. 14B, the thickness of the substrate 101 may be reduced, for example, using a Chemical Mechanical Polishing method. For example, an about 350 um-thick substrate 101 may be reduced to about 200 um. Then, Mesa etching is performed on the epitaxy layer 200 and the second contact layer 140 to expose parts of the first contact layer 102. First and second electrodes 161 and 162 may then be formed on the first and second contact layer 102, respectively.

Referring to FIG. 14C, during subsequent dry and wet etching processes, protection layers 151 and 152 may be formed to protect the first contact layer 102, the epitaxy layer 200, the second contact layer 140, the first electrode 161, and the second electrode 162. The protection layers 151, 152 may fully cover the bottom of the substrate 101, the second contact layer 140, the first electrode 161 and the second electrode 162. The protection layers 151, 152 may be made from SiO₂, for example.

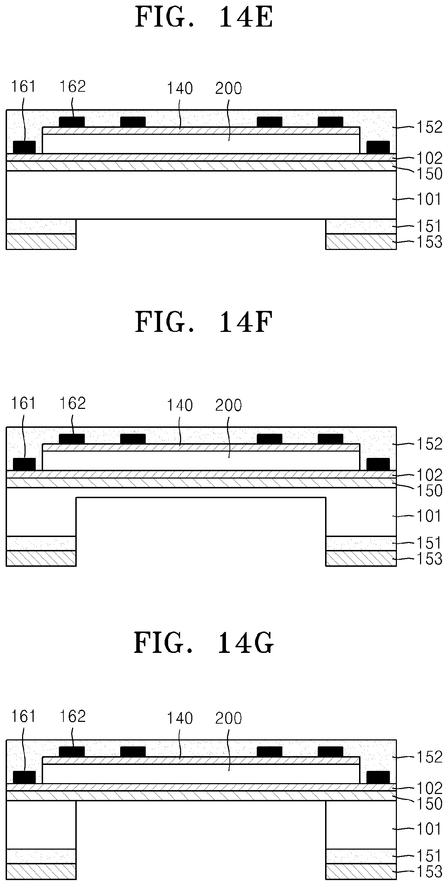

Next, as shown in FIG. 14D, a photoresist layer 153 is formed on the surface of the lower protection layer 151 by patterning. As a result, the photoresist layer 153 is formed along the edge of the lower protection layer 151, and a central part of the lower protection layer 151 is exposed to the outside. Then, as shown in FIG. 14E, the central part of the exposed lower protection layer 151 is removed through etching. As a result, the central part of the substrate 101 may be exposed to the outside.

Then, with a dry etching method, such as, Inductive Coupled Plasma (ICP) etching, for example, as shown in FIG. 14F, the central part of the substrate 101 may be removed. By dry etching, a part of the substrate 101 is not removed to an extent that the buffer layer 150 is exposed and a part of the substrate 101 remains. Next, as shown in FIG. 14G, with a wet etching method, the remaining part of the substrate 101 is finely etched. For example, as an etching solution, hydroxide solution (NH₄OH) may be used. The wet etching is performed until the remaining part of the substrate 101 is completely removed and the buffer layer 150 is exposed.

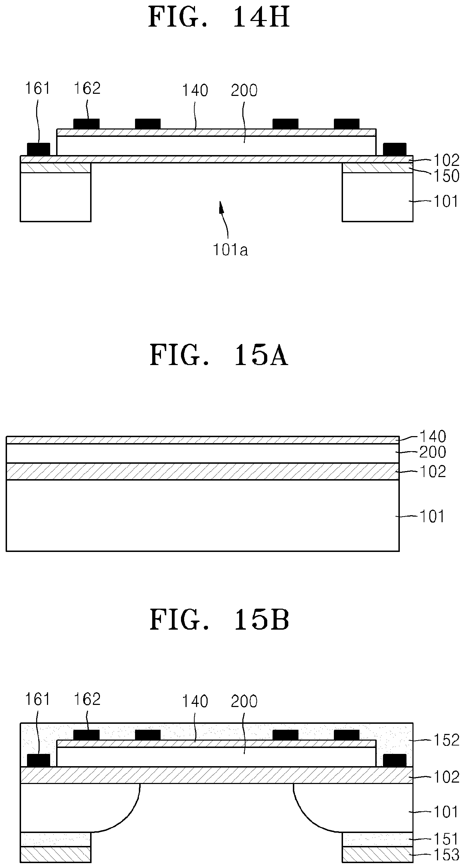

Finally, referring to FIG. 14H, SiO₂ of the lower and upper protection layers 151 and 152 may be removed with a buffer oxide etchant (BOE). At this time, the buffer layer 150 that is exposed through the central part of the substrate 101 may also be removed. According to the process described so far, the transparent window 101a may be formed in the substrate 101 while not damaging various film layers within the epitaxy layer 200.

In the process illustrated in FIGS. 14A to 14H, GaAs is used for the first contact layer 102. Alternatively, the transparent window 101a may be formed with a different method when other materials than GaAs are used for the first contact layer 102. For example, as a material for the first contact layer 102, InGaP may be used. InGaP allows light of about 850 nm wavelength to be transmitted and also to easily form an electrode thereon. Furthermore, InGaP may also serve as an etch stop layer for the hydroxide solution used as an etching solution.

FIGS. 15A to 15C are cross-sectional views schematically representing another process of forming the transparent window 101a of the substrate 101 when InGaP is used for the first contact layer 102.

First, referring to FIG. 15A, the first contact layer 102, the epitaxy layer 200, and the second contact layer 140 are grown on the GaAs substrate 101 in sequence. The first contact layer 102 may be, for example, made from n-InGaP while the second contact layer 140 may be made from p-GaAs. The epitaxy layer 200 may include the lower DBR layer 110, the active layer 120, and the upper DBR layer 130. On the contrary to GaAs, InGaP brings less light loss when used for the first contact layer 102. In this case, the first contact layer 102 may be formed as thick as possible, and thus, elaborateness of a subsequent process of etching the substrate 101 is not required.

After that, the same process as in FIGS. 14B to 14E is performed. That is, after the substrate 101 is polished, first and second electrodes 161 and 162 may be formed on the first and second contact layers 102 and 140, respectively. In addition, the protection layers 151 and 152 may be formed to cover the bottom of the substrate 101 and the second electrode 162. Then, the photoresist layer 153 may be formed along the edge of the lower protection layer 151, and a central part of the exposed lower protection layer 151 may be removed via etching.

Next, as shown in FIG. 15B, with a wet etching method, a part of the substrate 101 may be removed with an etching solution, such as, the hydroxide solution (NH₄OH). When InGaP is used as a material for the first contact layer 102, only a part of the substrate 101 may be removed in advance via dry etching. Etching continues until the substrate 101 is completely removed and the first contact layer 102 made from InGaP is exposed.

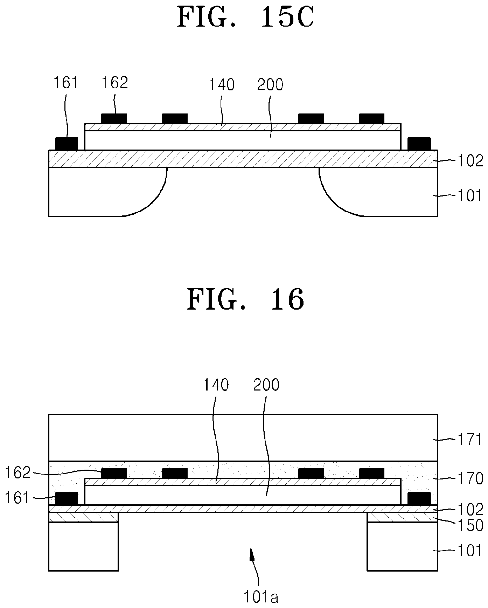

Finally, referring to FIG. 15C, SiO₂ of the lower and upper protection layers 151 and 152 may be removed with a proper BOE. At this time, the buffer layer 150 that is exposed through the central part of the substrate 101 may also be removed. According to the above process, the transparent window 101a may be more simply formed in the substrate 101 while not damaging various other film layers within the epitaxy layer 200 without a need for the buffer layer 150.

Since the transparent window 101a is formed in the substrate 101, the image modulator 100 may be weak to an external percussion. In this regard, as shown in FIG. 16, a transparent supporting structure may be mounted on the top of the image modulator 100. Referring to FIG. 16, transparent epoxy resin 170 is applied onto the top of the image modulator 100, on top of which a transparent cover 171 may be glued. The transparent cover 171 may be made from, for example, glass or transparent plastic materials. An anti-reflection layer, for example, may be coated on the transparent cover 171 on the light-entering side.

The image modulator 100 may be positioned, for example, before a photography device in a three dimensional image capturing device such that a modulated image may be provided to the photography device. In a case of manufacturing an image modulator to have the same size of a Charged-Coupled Device (CCD) or complementary metal-oxide semiconductor (CMOS), a capacitance of the image modulator 100 may be increased. The increase in capacitance in turn causes an increase of an RC time constant, thus limiting super-fast operations at about 20-40 MHz. Thus, in order to reduce the capacitance and a sheet resistance, a number of small image modulators 100 may be arranged and used in an array form.

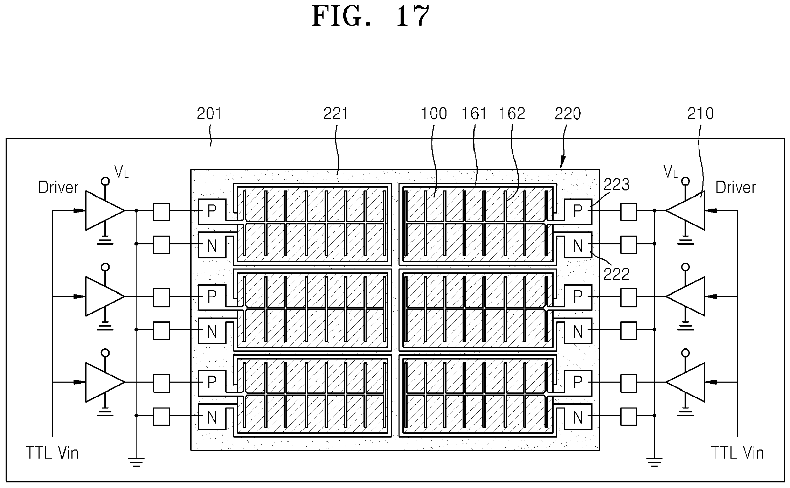

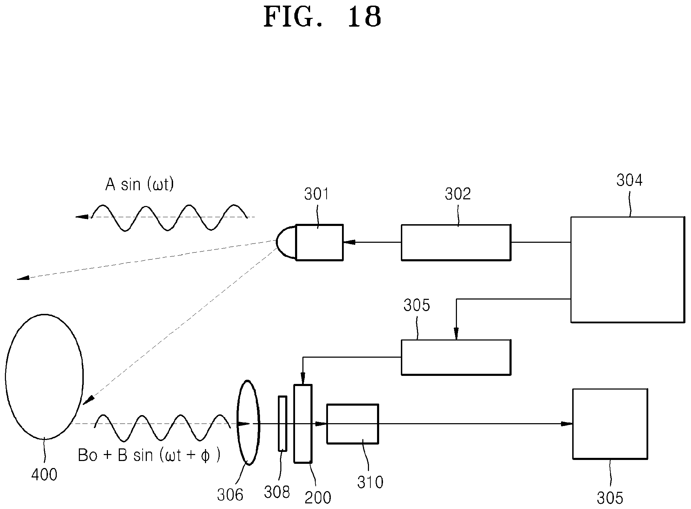

FIG. 17 schematically illustrates the image modulator array device 200 having the structure as described above. Referring to FIG. 17, the image modulator array device 200 may include a print circuit substrate 201, a number of driving circuits 210 arranged on the print circuit substrate 201, and an image modulator array 220 mounted on the print circuit substrate 201. As shown in FIG. 17, the image modulator array 220 may include an array of image modulators 100 arranged in an insulation layer 221. The number of driving circuits 210 and the image modulators 100 may be the same, wherein each driving circuit 210 may control a respective image modulator 100 independently. The second electrode 162 is disposed on the top surface of the image modulator 100 and is electrically connected to a second electrode pad 223 formed on the insulation layer 221. The second electrode pad 223 may be, in turn, electrically connected to a corresponding driving circuit 210. The second electrode 162 may be formed in a lattice in the shape of a fishbone, a matrix, or a mesh. In addition, the first electrode 161 is disposed along a circumference of the image modulator 100 and is electrically connected to a first electrode pad 222 formed on the insulation layer 221. The first electrode pad 222 may be connected to a common power source.

For the purpose of understanding the exemplary embodiments, the embodiments of transmissive image modulators employing multiple Fabry-Perot resonant modes and multiple absorption modes have been described and shown in the accompanying drawings. It should be understood that the exemplary embodiments described herein should be considered in a descriptive sense only and not for purposes of limitation. Descriptions of features or aspects within each embodiment should typically be considered as available for other similar features or aspects in other embodiments.

## Claims

1. A transmissive image modulator comprising,
a lower reflection layer (110);
an active layer (120) disposed on the lower reflection layer, the active layer comprising a plurality of quantum well layers and a plurality of barrier layers;
an upper reflection layer (130) disposed on the active layer; and
at least one micro-cavity layer disposed in each one of the lower and upper reflection layer,
wherein the active layer has an optical thickness which is a multiple of λ/2, and the at least one micro-cavity layer has an optical thickness which is a multiple of λ/2, where λ is a resonant wavelength to be modulated,
and **characterized in that** each of the lower reflection (110) and the upper reflection (130) comprises:
a first reflection layer (112,132);
a micro-cavity layer (111,131) disposed on the first reflection layer;
a phase matching layer (115,135) disposed on the micro-cavity layer; and
a second reflection layer (113,133) disposed on the phase matching layer,
wherein each of the first reflection layer (112, 132) and the second reflection layer (113, 133) is a distributed Bragg reflector (DBR) layer comprising first refractive index layers (110a, 130a) and second refractive index layers (110b, 130b) stacked alternately, wherein a first refractive index of the first refractive index layers is different from a second refractive index of the second refractive index layers, and wherein each of the first refractive index layers and each of the second refractive index layers has a thickness of λ/4,
wherein the phase matching layer (115, 135) is arranged so that low and high refractive layers alternate with each other.

2. The transmissive image modulator of claim 1, wherein:
the first reflection layer comprises first pairs of the first and second refractive index layers,
the micro-cavity layer comprises the first refractive index layer,
the phase matching layer comprises the second refractive index layer, and
the second reflection layer comprises second pairs of the first and second reflective layers,
and wherein a number of the first pairs is less than a number of the second pairs.

3. The transmissive image modulator of claim 2,
wherein the lower and upper reflection layers are disposed symmetrically about the active layer.

4. The transmissive image modulator of any of claims 2 to 3,
wherein each of the lower reflection layer and the upper reflection layer comprises a first and second reflection layers, and
wherein a reflectance of the first reflection layer of the lower reflection layer is the same as a reflectance of the second reflection layer of the upper reflection layer, and a reflectance of the second reflection layer of the lower reflection layer is the same as a reflectance of the first reflection layer of the upper reflection layer.

5. The transmissive image modulator of any of claims 2 to 4,
wherein each of the lower reflection layer and the upper reflection layer comprises a first and second reflection layers, and
wherein a phase of light reflected at the surface of the second reflection layer of the upper reflection layer lags by π, while phases of light reflected at surfaces of the first reflection layer of the lower reflection layer, the second reflection layer of the lower reflection layer, and the first reflection layer of the upper reflection layer are 0.

6. The transmissive image modulator of any of claims 2 to 5,
wherein the first refractive index layer is made from AlₓGa₁₋ₓAs, and the second refractive index layer is made from Al_{y}Ga_{1-y}AS, where 0 < x < 1, 0 < y < 1, and x < y.

7. The transmissive image modulator of any preceding claim,
wherein the active layer comprises the plurality of quantum well layers and the plurality of barrier layers stacked alternately, a first cladding layer disposed between the lower reflection layer and the active layer, and a second cladding layer disposed between the upper reflection layer and the active layer, and
wherein a refractive index of the first cladding layer is between a refractive index of the quantum well layer and a refractive index of the upper reflection layer,
a refractive index of the second cladding layer is between a refractive index of the quantum well layer and a refractive index of the lower reflection layer, and
the first cladding layer and the second cladding layer are made from the same material and have the same thickness.

8. The transmissive image modulator of claim 7,
wherein the multiple quantum well layer comprises first quantum well layers and second quantum well layers, wherein a thickness of the first quantum well layers is different from a thickness of the second quantum well layers.

9. The transmissive image modulator of any preceding claim,
further comprising, a first contact layer disposed on a lower surface of the lower reflection layer, and a second contact layer disposed on a top layer of the upper reflection layer,
and wherein the first contact layer is made from n-GaAs or n-InGaP.

10. The transmissive image modulator of claim 9,
further comprising, a substrate disposed on the lower surface of the first contact layer, and a transparent widow formed in a center of the substrate by removing a central part of the substrate,
and further comprising, a transparent resin applied to the second contact layer, and a transparent cover disposed on the transparent resin.

11. A method of forming a transmissive image modulator on a substrate, the method comprising,
forming a first contact layer (102) on a substrate (101);
forming the transmissive image modulator according to claim 1 on the first contact layer, forming a second contact layer (140) on a top surface of the upper reflection layer of the transmissive image modulator, and
forming a transparent window (101a) by removing a central part of the substrate.

12. The method of claim 11,
wherein the first contact layer is made from n-GaAs, the forming the first contact layer on the substrate comprises forming an AlAs buffer layer on the substrate, and forming the first contact layer on the AlAs buffer layer.

13. The method of claim 11,
wherein the forming the transparent window by removing the central part of the substrate comprises:
forming a first protection layer on a bottom surface of the substrate and forming a second protection layer on a top surface of the second contact layer;
forming a photoresist layer along an edge of the first protection layer, and removing a central part of the first protection layer to expose the substrate;
removing a portion of the exposed substrate with a dry etching;
removing a remaining part of the exposed substrate with a wet etching, this exposing the buffer layer; and
removing the exposed buffer layer and the first protection layer and the second protection layer,
or wherein the forming the transparent window by removing the central part of the substrate comprises:
forming a first protection layer on a bottom surface of the substrate and forming a second protection layer on a top surface of the second contact layer;
forming a photoresist layer along an edge of the first protection layer, and removing a central part of the first protection layer to expose the substrate;
removing an exposed part of the substrate with a wet etching method to expose the buffer layer; and
removing the exposed buffer layer and the first and second protection layers.

## Patentansprüche

1. Modulator für lichtdurchlässige Bilder, umfassend
eine untere Reflektionsschicht (110);
eine aktive Schicht (120), die auf der unteren Reflektionsschicht angeordnet ist, wobei die aktive Schicht eine Vielzahl von Quantenmuldenschichten und eine Vielzahl von Barrriereschichten umfasst;
eine obere Reflektionsschicht (130), die auf der aktiven Schicht angeordnet ist; und
mindestens eine Mikrohohlraumschicht, die in jeder der unteren und der oberen Reflektionsschicht angeordnet ist, wobei die aktive Schicht eine optische Dichte aufweist, die ein Vielfaches von λ/2 ist, und die mindestens eine Mikrohohlraumschicht eine optische Dicke aufweist, die ein Vielfaches von λ/2 ist, wobei λ eine zu modulierende Resonanzwellenlänge ist, und **dadurch gekennzeichnet, dass** jede der unteren Reflektionsschicht (110) und der oberen Reflektionsschicht (130) umfasst:
eine erste Reflektionsschicht (112, 132);
eine Mikrohohlraumschicht (111, 131), die auf der ersten Reflektionsschicht angeordnet ist;
eine Phasenanpassungsschicht (115, 135), die auf der Mikrohohlraumschicht angeordnet ist; und
eine zweite Reflektionsschicht (113, 133), die auf der Phasenanpassungsschicht angeordnet ist,
wobei jede der ersten Reflektionsschicht (112, 132) und der zweiten Reflektionsschicht (113, 133) eine DBR-(Distributed Bragg Reflector)-Schicht ist, umfassend erste Brechungsindexschichten (110a, 130a) und zweite Brechungsindexschichten (110b, 130b), die abwechselnd gestapelt sind,
wobei sich ein erster Brechungsindex der ersten Brechungsindexschichten von einem zweiten Brechungsindex der zweiten Brechungsindexschichten unterscheidet, und wobei jede der ersten Brechungsindexschichten und jede der zweiten Brechungsindexschichten eine Dicke von λ/4 aufweist, wobei die Phasenanpassungsschicht (115, 135) so angeordnet ist, dass Schichten mit einem niedrigen und einem hohen Brechungsindex einander abwechseln.

2. Modulator für lichtdurchlässige Bilder nach Anspruch 1, wobei: die erste Reflektionsschicht erste Paare der ersten und zweiten Brechungsindexschichten umfasst, die Mikrohohlraumschicht die erste Brechungsindexschicht umfasst,
die Phasenanpassungsschicht die zweite Brechungsindexschicht umfasst und
die zweite Reflektionsschicht zweite Paare der ersten und zweiten reflektierenden Schichten umfasst, und wobei eine Anzahl der ersten Paare geringer ist als eine Anzahl der zweiten Paare.

3. Modulator für lichtdurchlässige Bilder nach Anspruch 2, wobei die unteren und die oberen Reflektionsschichten symmetrisch um die aktive Schicht angeordnet sind.

4. Modulator für lichtdurchlässige Bilder nach einem der Ansprüche 2 bis 3, wobei jede der unteren Reflektionsschicht und der oberen Reflektionsschicht erste und zweite Reflektionsschichten umfasst und wobei eine Reflektivität der ersten Reflektionsschicht der unteren Reflektionsschicht dieselbe ist wie eine Reflektivität der zweiten Reflektionsschicht der oberen Reflektionsschicht ist und eine Reflektivität der zweiten Reflektionsschicht der unteren Reflektionsschicht dieselbe ist wie eine Reflektivität der ersten Reflektionsschicht der oberen Reflektionsschicht.

5. Modulator für lichtdurchlässige Bilder nach einem der Ansprüche 2 bis 4, wobei jede der unteren Reflektionsschicht und der oberen Reflektionsschicht erste und zweite Reflektionsschichten umfasst und wobei eine Phase des an der Oberfläche der zweiten Reflektionsschicht der oberen Reflektionsschicht reflektierten Lichts um π verzögert ist, während Phasen des an den Oberflächen der ersten Reflektionsschicht der unteren Reflektionsschicht, der zweiten Reflektionsschicht der unteren Reflektionsschicht und der ersten Reflektionsschicht der oberen Reflektionsschicht reflektierten Lichts 0 sind.

6. Modulator für lichtdurchlässige Bilder nach einem der Ansprüche 2 bis 5, wobei die erste Brechungsindexschicht aus AlₓGa₁₋ₓAs hergestellt ist und die zweite Brechungsindexschicht aus Al_{y}Ga_{1-y}AS hergestellt ist, wobei 0 < x < 1, 0 < y < 1 und x < y.

7. Modulator für lichtdurchlässige Bilder nach einem der vorstehenden Ansprüche, wobei die aktive Schicht die Vielzahl von Quantenmuldenschichten und die Vielzahl von Barriereschichten abwechselnd gestapelt, eine erste Verkleidungsschicht zwischen der unteren Reflektionsschicht und der aktiven Schicht angeordnet und eine zweite Verkleidungsschicht zwischen der oberen Reflektionsschicht und der aktiven Schicht angeordnet umfasst und wobei ein Brechungsindex der ersten Verkleidungsschicht zwischen einem Brechungsindex der Quantenmuldenschicht und einem Brechungsindex der oberen Reflektionsschicht ist, ein Brechungsindex der zweiten Verkleidungsschicht zwischen einem Brechungsindex der Quantenmuldenschicht und einem Brechungsindex der unteren Reflektionsschicht ist, und die erste Verkleidungsschicht und die zweite Verkleidungsschicht aus demselben Material hergestellt sind und dieselbe Dicke aufweisen.

8. Modulator für lichtdurchlässige Bilder nach Anspruch 7, wobei die mehreren Quantenmuldenschichten erste Quantenmuldenschichten und zweite Quantenmuldenschichten umfasst, wobei sich eine Dicke der ersten Quantenmuldenschichten von einer Dicke der zweiten Quantenmuldenschichten unterscheidet.

9. Modulator für lichtdurchlässige Bilder nach einem der vorstehenden Ansprüche, ferner umfassend eine erste Kontaktschicht, die auf einer unteren Oberfläche der unteren Reflektionsschicht angeordnet ist, und eine zweite Kontaktschicht, die auf einer oberen Schicht der oberen Reflektionsschicht angeordnet ist, und wobei die erste Kontaktschicht aus n-GaAs oder n-InGaP hergestellt ist.

10. Modulator für lichtdurchlässige Bilder nach Anspruch 9, ferner umfassend ein auf der unteren Oberfläche der ersten Kontaktschicht angeordnetes Substrat, und ein transparentes Fenster, das in einem Zentrum des Substrats durch Entfernen eines zentralen Teils des Substrats geformt ist, und ferner umfassend ein auf die zweite Kontaktschicht aufgetragenes transparentes Harz, und eine transparente Abdeckung, die auf dem transparenten Harz angeordnet ist.

11. Verfahren zum Formen eines Modulators für lichtdurchlässige Bilder auf einem Substrat, wobei das Verfahren umfasst, Formen einer ersten Kontaktschicht (102) auf einem Substrat (101); Formen des Modulators für lichtdurchlässige Bilder nach Anspruch 1 auf der ersten Kontaktschicht, Formen einer zweiten Kontaktschicht (140) auf einer oberen Oberfläche der oberen Reflektionsschicht des Modulators für lichtdurchlässige Bilder und Formen eines transparenten Fensters (101a) durch Entfernen eines zentralen Teils des Substrats.

12. Verfahren nach Anspruch 11, wobei die erste Kontaktschicht aus n-GaAs hergestellt ist, das Formen der ersten Kontaktschicht auf dem Substrat das Formen einer AlAs-Pufferschicht auf dem Substrat und das Formen der ersten Kontaktschicht auf der AlAs-Pufferschicht umfasst.

13. Verfahren nach Anspruch 11, wobei das Formen des transparenten Fensters durch Entfernen des zentralen Teils des Substrats umfasst:
Formen einer ersten Schutzschicht auf einer unteren Oberfläche des Substrats und Formen einer zweiten Schutzschicht auf einer oberen Oberfläche der zweiten Kontaktschicht;
Formen einer Photoresistschicht entlang einer Kante der ersten Schutzschicht und Entfernen eines zentralen Teils der ersten Schutzschicht, um das Substrat freizulegen; Entfernen eines Abschnitts des freigelegten Substrats mithilfe von Trockenätzen; Entfernen eines verbleibenden Teils des freigelegten Substrats mithilfe von Nassätzen, dadurch Freilegen der Pufferschicht; und
Entfernen der freigelegten Pufferschicht und der ersten Schutzschicht und der zweiten Schutzschicht, oder wobei das Formen des transparenten Fensters durch Entfernen des zentralen Teils des Substrats umfasst:
Formen einer ersten Schutzschicht auf einer unteren Oberfläche des Substrats und Formen einer zweiten Schutzschicht auf einer oberen Oberfläche der zweiten Kontaktschicht;
Formen einer Photoresistschicht entlang einer Kante der ersten Schutzschicht und Entfernen eines zentralen Teils der ersten Schutzschicht, um das Substrat freizulegen;
Entfernen eines freigelegten Teils des Substrats mit einem Nassätzverfahren, um die Pufferschicht freizulegen; und
Entfernen der freigelegten Pufferschicht und der ersten und zweiten Schutzschichten.

## Revendications

1. Modulateur d'image transmissive comprenant :
une couche réfléchissante inférieure (110) ;
une couche active (120) disposée sur la couche réfléchissante inférieure, la couche active comprenant une pluralité de couches de puits quantiques et une pluralité de couches barrière ;
une couche réfléchissante supérieure (130) disposée sur la couche active ; et
au moins une couche à microcavité disposée sur chacune des couches réfléchissantes inférieure et supérieure, l'épaisseur optique de la couche active étant un multiple de λ/2, et l'épaisseur optique de l'au moins une couche à microcavité étant un multiple de λ/2, λ étant une longueur d'onde résonante à moduler, et
**caractérisé en ce que** chacune de la couche réfléchissante inférieure (110) et de la couche réfléchissante supérieure (130) comprend :
une première couche réfléchissante (112,132) ;
une couche de microcavité (111, 131) disposée sur la première couche réfléchissante ;
une couche d'accord de phase (115,135) disposée sur la couche de microcavité ;
et une deuxième couche réfléchissante (113,133) disposée sur la couche d'accord de phase, chacune de la première couche réfléchissante (112,132) et de la deuxième couche réfléchissante (113,133) étant un réflecteur de Bragg distribué (DBR) comprenant des premières couches à indice de réfraction (110a, 130a) et des deuxièmes couches à indice de réfraction (110b, 130b) empilées de façon alternée, un premier indice de réfraction des premières couches à indice de réfraction étant différent d'un deuxième indice de réfraction des deuxièmes couches à indice de réfraction, et l'épaisseur de chacune des premières couches à indice de réfraction et de chacune des deuxièmes couches à indice de réfraction étant λ/4, la couche d'accord de phase (115,135) étant agencée de sorte que des couches à faible et à haute réfraction s'alternent entre elles.

2. Modulateur d'image transmissive selon la revendication 1, la première couche réfléchissante comprenant des premières et deuxième couches à indice de réfraction, la couche à microcavité comprenant la première couche à indice de réfraction, la couche d'accord de phase comprenant la deuxième couche à indice de réfraction, et la deuxième couche réfléchissante comprenant des deuxièmes paires des premières et deuxième couches réfléchissantes, un nombre des premières paires étant inférieur à un nombre des deuxièmes paires.

3. Modulateur d'image transmissive selon la revendication 2, les couches réfléchissantes inférieures et supérieures étant disposées symétriquement autour de la couche active.

4. Modulateur d'image transmissive selon une quelconque des revendications 2 à 3, chacune de la couche réfléchissante inférieure et de la couche réfléchissante supérieure comprenant des premières et deuxième couches réfléchissantes, et une réflectance de la première couche réfléchissante de la couche réfléchissante inférieure étant la même qu'une réflectance de la deuxième couche réfléchissante de la couche réfléchissante supérieure, et une réflectance de la deuxième couche réfléchissante de la couche réfléchissante inférieure étant la même qu'une réflectance de la première couche réfléchissante de la couche réfléchissante supérieure.

5. Modulateur d'image transmissive selon une quelconque des revendications 2 à 4, chacune de la couche réfléchissante inférieure et de la couche réfléchissante supérieure comprenant des premières et deuxième couches réfléchissantes, et une phase de lumière réfléchie sur la surface de la deuxième couche réfléchissante de la couche réfléchissante supérieure accusant un retard π, tandis que des phases de lumière réfléchies sur la surface de la première couche réfléchissante de la couche réfléchissante inférieure, la deuxième couche réfléchissante de la couche réfléchissante inférieure, et la première couche réfléchissante de la couche réfléchissante supérieure étant 0.

6. Modulateur d'image transmissive selon une quelconque des revendications 2 à 5, la première couche d'indice de réfraction étant composée de AlₓGa₁₋ₓAs, et la deuxième couche d'indice de réfraction étant composée de Al_{y}Ga_{1-y}AS, où 0 < x < 1, 0 < y < 1, et x < y.

7. Modulateur d'image transmissive selon une quelconque des revendications précédentes, la couche active comprenant, empilées en alternance, la pluralité de couches de puits quantiques et la pluralité de couches barrière, une première couche de revêtement étant disposée entre la couche réfléchissante inférieure et la couche active, et une deuxième couche de revêtement étant disposée entre la couche réfléchissante supérieure et la couche active, et un indice de réfraction de la première couche de revêtement étant compris entre un indice de réfraction de la couche de puits quantique et un indice de réfraction de la couche réfléchissante supérieure, un indice de réfraction de la deuxième couche de revêtement étant situé entre un indice de réfraction de la couche de puits quantique et un indice de réfraction de la couche réfléchissante inférieure, et la première couche de revêtement et la deuxième couche de revêtement étant réalisées avec le même matériau et mesurant la même épaisseur.

8. Modulateur d'image transmissive selon la revendication 7, la multiple couche de puits quantique comprenant des premières couches de puits quantique et des deuxième couches de puits quantique, une épaisseur des premières couches de puits quantique étant différente d'une épaisseur des deuxième couches de puits quantique.

9. Modulateur d'image transmissive selon une quelconque des revendications précédentes, comprenant en outre une première couche de contact disposée sur une surface inférieure de la couche réfléchissante inférieure, et une deuxième couche de contact disposée sur une surface supérieure de la couche réfléchissante supérieure, et la première couche de contact étant réalisée en n-GaAs ou en n-InGaP.

10. Modulateur d'image transmissive selon la revendication 9, comprenant en outre un substrat disposé sur la surface inférieure de la première couche de contact, et une fenêtre transparente formée dans un centre du substrat en enlevant une partie centrale du substrat, et comprenant en outre une résine transparente appliquée sur la deuxième couche de contact, et un revêtement transparent disposé sur la résine transparente.

11. Méthode de formation d'un modulateur d'image transmissive sur un substrat, la méthode comprenant :
la formation d'une première couche de contact (102) sur un substrat (101) ;
la formation d'un modulateur d'image transmissive selon la revendication 1 sur la première couche de contact, la formation d'une deuxième couche de contact (140) sur une surface supérieure de la couche réfléchissante supérieure du modulateur d'image transmissive, et la formation d'une fenêtre transparente (101a) en enlevant une partie centrale du substrat.

12. Méthode selon la revendication 11, la première couche de contact étant réalisée en n-GaAs, la formation de la première couche de contact sur le substrat comprenant la formation d'une couche tampon AlAs sur le substrat, et la formation de la première couche de contact sur la couche tampon AlAs.

13. Méthode selon la revendication 11, la formation d'une fenêtre transparente en enlevant une partie centrale du substrat comprenant :
la formation d'une première couche de protection sur une surface inférieure du substrat, et la formation d'une deuxième couche de protection sur une surface supérieure de la deuxième couche de contact ;
la formation d'une couche de résine photosensible le long d'un bord de la première couche de protection, et l'enlèvement d'une partie centrale de la première couche de protection afin d'exposer le substrat ;
l'enlèvement d'une partie du substrat exposé par gravure à sec ;
l'enlèvement d'une partie restante du substrat exposé par gravure humide, en exposant ainsi la couche tampon ;
et l'enlèvement de la couche tampon exposée, de la première couche de protection et de la deuxième couche de protection, ou la formation de la fenêtre transparente en enlevant la partie centrale du substrat comprenant :
la formation d'une première couche de protection sur une surface inférieure du substrat, et la formation d'une deuxième couche de protection sur une surface supérieure de la deuxième couche de contact ;
la formation d'une couche de résine photosensible le long d'un bord de la première couche de protection, et l'enlèvement d'une partie centrale de la première couche de protection afin d'exposer le substrat ;
l'enlèvement d'une partie restante du substrat exposé par gravure humide, en exposant ainsi la couche tampon ;
et l'enlèvement de la couche tampon exposée, et des première et deuxième couches de protection.
